(19) Europäisches Patentamt
European Patent Office
Office européen des brevets

(11) EP 4 015 458 A1

(12) EUROPEAN PATENT APPLICATION
published in accordance with Art. 153(4) EPC

(43) Date of publication:
22.06.2022 Bulletin 2022/25

(51) International Patent Classification (IPC):
C01G 9/00 (2006.01)      H01C 7/112 (2006.01)
H01C 17/30 (2006.01)      C04B 35/453 (2006.01)
C23C 14/34 (2006.01)

(21) Application number: 20852547.7

(22) Date of filing: 12.08.2020

(52) Cooperative Patent Classification (CPC):
C01G 9/00; C04B 35/453; C23C 14/34;
H01C 7/112; H01C 17/30

(86) International application number:
PCT/JP2020/030670

(87) International publication number:
WO 2021/029421 (18.02.2021 Gazette 2021/07)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 15.08.2019 JP 2019149136

(71) Applicant: JFE Mineral Company, Ltd.
Tokyo 105-0014 (JP)

(72) Inventors:
• NAKATA Yoshimi
Tokyo 105-0014 (JP)
• UDAGAWA Etsurou
Tokyo 105-0014 (JP)

(74) Representative: Grünecker Patent- und
Rechtsanwälte
PartG mbB
Leopoldstraße 4
80802 München (DE)

(54) ZINC OXIDE POWDER FOR PRODUCING ZINC OXIDE SINTERED BODY, ZINC OXIDE SINTERED BODY, AND METHODS FOR PRODUCTION THEREOF

(57) Provided is zinc oxide powder for producing a zinc oxide sintered body in which mass reduction during a firing process is suppressed. The zinc oxide powder contains a metal element M and satisfies Condition 1 or Condition 2 below: (Condition 1) the metal element M is a metal element M1-1 that is at least one selected from the group consisting of Bi, Co, Cr, Cu, In, Ni, Mn and Sb, or a combination of the metal element M1-1 and a metal element M2 that is at least one selected from the group consisting of Al and Ga, and a content of the metal element M is not less than 10 mol ppm and not more than 10 mol%; and (Condition 2) the metal element M is a metal element Ml-2 that is at least one selected from the group consisting of Ba, Ce, La, Nb, Pr and Sr, or a combination of the metal element M1-2 and the metal element M2, and a content of the metal element M is not less than 10 mol ppm and not more than 2 mol%.

EP 4 015 458 A1

**Description**

TECHNICAL FIELD

The present invention relates to zinc oxide powder for producing a zinc oxide sintered body, a zinc oxide sintered body, and methods for producing them.

BACKGROUND ART

Conventionally, various kinds of zinc oxide powder produced by different methods have been known (see Patent Literature 1, for example).

CITATION LIST

PATENT LITERATURE

Patent Literature 1: JP 2009-269946 A

SUMMARY OF INVENTION

TECHNICAL PROBLEMS

Zinc oxide powder is arbitrarily compacted and subsequently fired. A zinc oxide sintered body in which zinc oxide powder has been sintered is thus obtained.

When zinc oxide powder is fired (in particular, fired in an atmosphere such as a high-temperature air atmosphere or a low-oxygen partial pressure atmosphere), mass reduction takes place in some cases.

A large mass reduction may, for example, lower the strength or change the electric characteristics or optical characteristics of a zinc oxide sintered body to be obtained. Moreover, it is concerned that a large mass reduction causes zinc contamination in an inside of a furnace used for the firing process due to vaporization of zinc.

Therefore, the present invention has an object to provide zinc oxide powder for producing a zinc oxide sintered body in which mass reduction during a firing process is suppressed.

Another object of the present invention is to provide a zinc oxide sintered body obtained using the foregoing zinc oxide powder for producing a zinc oxide sintered body.

Yet another object of the present invention is to provide a method for preparing the zinc oxide powder for producing a zinc oxide sintered body and a method for producing the zinc oxide sintered body.

SOLUTION TO PROBLEMS

The inventors found, though an earnest study, that employing the constitutions described below enables the achievement of the above-mentioned objects.

Specifically, the present invention provides the following [1] to [8].

[1] Zinc oxide powder for producing a zinc oxide sintered body, the zinc oxide powder being used to produce a zinc oxide sintered body, containing a metal element M and satisfying Condition 1 or Condition 2 below: Condition 1

the metal element M is a metal element M1-1 that is at least one selected from the group consisting of Bi, Co, Cr, Cu, In, Ni, Mn and Sb, or a combination of the metal element M1-1 and a metal element M2 that is at least one selected from the group consisting of Al and Ga, and
a content of the metal element M represented by Formula (I) below is not less than 10 mol ppm and not more than 10 mol%; and

Condition 2

the metal element M is a metal element M1-2 that is at least one selected from the group consisting of Ba, Ce, La, Nb, Pr and Sr, or a combination of the metal element M1-2 and a metal element M2 that is at least one selected from the group consisting of Al and Ga, and
a content of the metal element M represented by Formula (I) below is not less than 10 mol ppm and not more than 2 mol%,

$$\{n_M/(n_{Zn} + n_M)\} \qquad (I)$$

where $n_M$ represents an amount of substance of the metal element M in the zinc oxide powder, $n_{Zn}$ represents an amount of substance of Zn in the zinc oxide powder, and a unit for both $n_{Zn}$ and $n_M$ is mole.

[2] The zinc oxide powder for producing a zinc oxide sintered body according to [1], wherein a coefficient of variation C.V. value determined through EPMA mapping measurement of the metal element M is not more than 30%.

[3] The zinc oxide powder for producing a zinc oxide sintered body according to [1], wherein an integrated intensity ratio determined through EPMA mapping measurement of the metal element M is preferably not more than 0.1%.

[4] The zinc oxide powder for producing a zinc oxide sintered body according to any one of [1] to [3], wherein the zinc oxide powder is obtained by subjecting basic zinc carbonate containing the metal element M to heat treatment, the basic zinc carbonate being generated by a precipitate forming reaction of a salt of the metal element M with a zinc salt, a carbonate and an alkali.

[5] A zinc oxide sintered body, wherein the zinc oxide powder for producing a zinc oxide sintered body according to any one of [1] to [4] is sintered.

[6] The zinc oxide sintered body according to [5], wherein the zinc oxide sintered body is a sputter target, a gas sensor, a varistor or a ceramic structure of a high-temperature furnace.

[7] A method for preparing zinc oxide powder for producing a zinc oxide sintered body, the method comprising: generating basic zinc carbonate containing the metal element M by a precipitate forming reaction of a salt of the metal element M with a zinc salt, a carbonate and an alkali; and
subjecting the basic zinc carbonate to heat treatment, whereby the zinc oxide powder for producing a zinc oxide sintered body according to any one of [1] to [4] is obtained.

[8] A method for producing a zinc oxide sintered body, the method comprising: firing the zinc oxide powder for producing a zinc oxide sintered body according to any one of [1] to [4] in a high-temperature air atmosphere at not lower than 800°C or in a low-oxygen partial pressure atmosphere at not higher than $1.0 \times 10^{-3}$ MPa, whereby a zinc oxide sintered body into which the zinc oxide powder for producing a zinc oxide sintered body is sintered is obtained.

ADVANTAGEOUS EFFECTS OF INVENTION

According to the present invention, it is possible to provide zinc oxide powder for producing a zinc oxide sintered body in which mass reduction during a firing process is suppressed.

According to the present invention, it is also possible to provide a zinc oxide sintered body obtained using the zinc oxide powder for producing a zinc oxide sintered body.

According to the present invention, it is also possible to provide a method for preparing the zinc oxide powder for producing a zinc oxide sintered body and a method for producing the zinc oxide sintered body.

DESCRIPTION OF EMBODIMENTS

[Zinc Oxide Powder]

Zinc oxide powder for producing a zinc oxide sintered body according to the present invention (hereinafter, also simply referred to as "zinc oxide powder of the invention") is zinc oxide powder to be used to produce a zinc oxide sintered body, contains a metal element M, and satisfies Condition 1 or Condition 2 below.

(Condition 1)

The metal element M is a metal element M1-1 that is at least one selected from the group consisting of Bi, Co, Cr, Cu, In, Ni, Mn and Sb, or a combination of the metal element M1-1 and a metal element M2 that is at least one selected from the group consisting of Al and Ga.

A content of the metal element M represented by the following Formula (I) (proportion of an amount of substance of the metal element M) is not less than 10 mol ppm and not more than 10 mol%.

(Condition 2)

The metal element M is a metal element M1-2 that is at least one selected from the group consisting of Ba, Ce, La, Nb, Pr and Sr, or a combination of the metal element M1-2 and a metal element M2 that is at least one selected from the group consisting of Al and Ga.

A content of the metal element M represented by the following Formula (I) (proportion of an amount of substance of the metal element M) is not less than 10 mol ppm and not more than 2 mol%.

$$\{n_M / (n_{Zn} + n_M)\} \qquad (I)$$

In Formula (I), $n_M$ represents an amount of substance of the metal element M in the zinc oxide powder, nzn represents an amount of substance of Zn in the zinc oxide powder, and a unit for both nzn and $n_M$ is mole.

The difference in the atomic radius or the ionic radius between the metal element M1-1 and Zn is not more than 30%. The difference in the atomic radius or the ionic radius between the metal element Ml-2 and Zn is more than 30%.

The zinc oxide powder of the invention is fired, whereby the zinc oxide sintered body is obtained as described below.

In this process, the zinc oxide powder of the invention may be fired in a high-temperature air atmosphere at not lower than 800°C or in a low-oxygen partial pressure atmosphere at not higher than $1.0 \times 10^{-3}$ MPa (hereinafter, also referred to as "specific atmosphere" for convenience).

By satisfying the above-described Condition 1 or Condition 2, even when the zinc oxide powder of the invention is fired in the specific atmosphere, mass reduction can be suppressed.

A presumable reason for such suppression is because the metal element M in an appropriate amount contributes to an improvement in the bond strength between zinc and oxygen, while any other reason therefor is also construed as being encompassed by the invention.

The temperature of the high-temperature air atmosphere is not lower than 800°C and may be 1,000°C or higher or 1,200°C or higher. The upper limit thereof is not particularly limited and is, for example, not higher than 2,000°C and may be 1,800°C or lower.

The oxygen partial pressure of the low-oxygen partial pressure atmosphere is not higher than $1.0 \times 10^{-3}$ MPa and may be $1.0 \times 10^{-4}$ or lower, $1.0 \times 10^{-5}$ MPa or lower, $1.0 \times 10^{-8}$ MPa or lower or $1.0 \times 10^{-9}$ MPa or lower. The lower limit thereof is not particularly limited and is, for example, not lower than $1.0 \times 10^{-13}$ MPa and may be $1.0 \times 10^{-12}$ MPa or higher.

Because the mass reduction can be further suppressed, the content of the metal element M is preferably not less than 20 mol ppm, more preferably not less than 50 mol ppm, further preferably not less than 100 mol ppm, and particularly preferably not less than 200 mol ppm.

When the above-described Condition 1 is satisfied, because the mass reduction can be further suppressed, the content of the metal element M is preferably not more than 8 mol%, more preferably not more than 6 mol%, further preferably not more than 4 mol%, and particularly preferably not more than 2 mol%.

Similarly, when the above-described Condition 2 is satisfied, because the mass reduction can be further suppressed, the content of the metal element M is preferably not more than 1.5 mol%, more preferably not more than 1 mol%, further preferably not more than 0.5 mol%, and particularly preferably not more than 0.2 mol%.

When the metal element M2 is further contained as the metal element M, the conductivity is excellent. This is presumably because Al and Ga serve as a carrier.

Because the conductivity is more excellent, the content of the metal element M2 is preferably not less than 10 mol ppm, more preferably not less than 50 mol ppm, further preferably not less than 100 mol ppm, and particularly preferably not less than 150 mol ppm.

Because precipitation of a heterogeneous phase is suppressed while the conductivity is more excellent, the content of the metal element M2 is preferably not more than 2,000 mol ppm, more preferably not more than 1,200 mol ppm, further preferably not more than 800 mol ppm, and particularly preferably not more than 300 mol ppm.

The zinc oxide powder of the invention preferably has a crystallite size determined by the X-ray diffraction (hereinafter, also simply referred to as "crystallite size") of 20 to 300 nm, a particle size determined by the BET method (hereinafter, also simply referred to as "BET diameter") of 20 to 350 nm, an untamped density (hereinafter, also simply referred to as "bulk density") of not less than 0.20 g/cm³, and a tap density of not less than 0.60 g/cm³.

The untamped density is obtained using the method according to JIS R 9301-2-3. That is, into a 100 mL-volume container standing still, zinc oxide powder is allowed to freely fall, and a mass of the collected zinc oxide powder is determined. The mass divided by the volume of the container is determined as the untamped density.

The tap density is determined as described below. First, zinc oxide powder is put in the same container as above, and the container is tapped using a tapping device until the volume of the zinc oxide powder no longer decreases. The mass of the zinc oxide powder is divided by the volume of the zinc oxide powder after tapping, and the obtained value is regarded as the tap density.

<Coefficient of variation C.V. value>

In the zinc oxide powder of the invention, the coefficient of variation C.V. value determined through EPMA mapping measurement of the metal element M is preferably not more than 30% and more preferably not more than 25%. When the coefficient of variation C.V. value falls under this range, the metal element M is evenly dispersed in the zinc oxide powder, and mass reduction can be further suppressed.

The coefficient of variation C.V. value is determined as described below.

First, a specimen of zinc oxide powder is pressure-formed to prepare a pellet with a diameter of 10 mm.

The prepared pellet is subjected to Pt-Pd deposition, and thereafter mapping measurement of the metal element M is performed with an electron probe micro analyzer (EPMA).

The measurement conditions include an acceleration voltage of 15kV, a beam current of 200 nA, a beam diameter of 2 $\mu$m, a step size of 2 $\mu$m, the number of measurement points of 150 × 330 points, an analysis region of 300 $\mu$m × 660 $\mu$m, and the integrated time of 50 milliseconds.

At all the measurement points of the metal element M mapping with an EPMA, the average intensity and the standard deviation are determined. The standard deviation is divided by the average intensity, and the resulting value expressed by percentage is regarded as a coefficient of variation C.V. value (unit: %).

<Integrated intensity ratio>

In the zinc oxide powder of the invention, the integrated intensity ratio determined through EPMA mapping measurement of the metal element M is preferably not more than 0.1% and more preferably not more than 0.05%. When the integrated intensity ratio falls under this range, the metal element M is evenly dispersed in the zinc oxide powder, and mass reduction can be further suppressed.

The integrated intensity ratio is determined as described below.

First, as with the case of determining the coefficient of variation C.V. value, mapping measurement of the metal element M is performed with an electron probe micro analyzer (EPMA).

Using the intensities at the respective measurement points in the metal element M mapping with an EPMA, a histogram with a horizontal axis showing the intensity at each measurement point and a vertical axis showing the frequency is prepared. A value obtained by adding a value of 10 times a square root of the mode intensity to the mode intensity is regarded as a threshold. The integrated intensity ratio (unit: %) of a region where the intensities are equal to or larger than the threshold to the whole intensity (integration of the whole region) is calculated.

<Preparation method of zinc oxide powder>

As the method for preparing the zinc oxide powder of the invention, preferred is a method in which basic zinc carbonate containing the metal element M is generated by a precipitate forming reaction of a salt of the metal element M with a zinc salt, a carbonate and an alkali, and the generated basic zinc carbonate is subjected to heat treatment, whereby the zinc oxide powder of the invention is obtained (hereinafter, also referred to as "powder preparation method of the invention" for convenience).

Compared to zinc oxide powder obtained by another method such as a solid phase method (method in which powder of an oxide of the metal element M is added to and mixed with zinc oxide powder), given that the content of the metal element M does not vary, the zinc oxide powder obtained by the powder preparation method of the invention experiences less vaporization of zinc, suppressing mass reduction during the firing process in the specific atmosphere.

The reason why the above-described effect can be obtained by the powder preparation method of the invention is probably because, for example, the zinc oxide powder undergoes the state of basic zinc carbonate (precursor) containing the metal element M, whereby the metal element M is uniformly present in the obtained zinc oxide powder on a molecular level, contributing to an improvement in the bond strength between zinc and oxygen.

In the powder preparation method of the invention, it is preferable that a salt of the metal element M, a zinc salt, a carbonate and an alkali are all used in the form of aqueous solution.

In the precipitate forming reaction, specifically, an aqueous solution of a zinc salt and an aqueous solution of a salt of the metal element M (preferably a mixed aqueous solution of a zinc salt and a salt of the metal element M), for example, are preferably added dropwise to an aqueous solution of a carbonate. During the dropwise addition, the pH of the aqueous solution of a carbonate is preferably kept at a constant value with an aqueous solution of an alkali being supplied to the aqueous solution of a carbonate.

The pH kept at a constant value is preferably not less than 6.0 and more preferably not less than 7.0. Meanwhile, the pH is preferably not more than 10.0, more preferably not more than 9.0 and further preferably not more than 8.0.

Through the precipitate forming reaction, the basic zinc carbonate is obtained in the form of a precipitate. The precipitate is preferably stirred.

The stirring time is preferably at least 1 hour, more preferably at least 5 hours, even more preferably at least 10 hours, and particularly preferably at least 15 hours. When the stirring time is long, the obtained zinc oxide powder has a high untamped density and a high tap density, compared to the case where the stirring time is short, given that the content of the metal element M does not vary. In addition, the use of the obtained zinc oxide powder leads to high densities of a green compact and a sintered body.

When the stirring time is short, the primary particles are probably likely to bond together into a flake shape which is a characteristic shape of a layered hydroxide. With a long stirring time, on the contrary, the primary particles probably repeatedly collide each other due to the stirring to eliminate the flake shape, and are likely formed into a granular shape.

While the stirring time depends on the concentration of the solution, the stirring force or another factor, the upper limit thereof is not particularly limited, and the stirring time is, for instance, not longer than 32 hours and preferably not longer than 24 hours.

During the precipitate forming reaction and the stirring process, the aqueous solution of a carbonate is kept at temperature of preferably lower than 45°C and more preferably not higher than 25°C.

A salt of the metal element M is preferably a salt having excellent water solubility, and preferred examples thereof include a nitrate of the metal element M, a chloride of the metal element M, a sulfate of the metal element M, and hydrates thereof.

A zinc salt is preferably a salt having excellent water solubility, and preferred examples thereof include zinc nitrate, zinc sulphate, zinc chloride, zinc acetate, and hydrates thereof.

An alkali is not particularly limited, and preferred examples thereof include sodium hydroxide and potassium hydroxide. When the alkali is in the form of aqueous solution, it may be aqueous ammonia.

Examples of a carbonate include ammonium carbonate, sodium carbonate and sodium hydrogen carbonate (sodium bicarbonate).

When the obtained zinc oxide powder of the invention satisfies the above-described Condition 1, the basic zinc carbonate generated by the precipitate forming reaction preferably contains basic zinc carbonate represented by Formula (1) below.

$$(Zn_{1-x}M_x)_{4-6}(CO_3)_{1-3}(OH)_{6-7} \cdot nH_2O \qquad (1)$$

In Formula (1), x represents a number of $1 \times 10^{-5}$ to 0.1, and n represents an integer of 0 to 2.

When the obtained zinc oxide powder of the invention satisfies the above-described Condition 2, the basic zinc carbonate generated by the precipitate forming reaction preferably contains basic zinc carbonate represented by Formula (2) below.

$$(Zn_{1-x}M_x)_{4-6}(CO_3)_{1-3}(OH)_{6-7} \cdot nH_2O \qquad (2)$$

In Formula (2), x represents a number of $1 \times 10^{-5}$ to 0.02, and n represents an integer of 0 to 2.

The basic zinc carbonate represented by Formula (1) or (2) above can be regarded as basic zinc carbonate in which part of zinc in hydrozincite $(Zn_5(CO_3)_2(OH)_6 \cdot 2H_2O)$ is substituted with the metal element M, and which contains the metal element M evenly in the molecular level. For convenience, this basic zinc carbonate may be called hydrozincite hereinbelow. In the meantime, when an excessive amount of the metal element M is contained, a double hydroxide different from hydrozincite may be formed. The basic zinc carbonate generated by the precipitate forming reaction preferably comprises the foregoing hydrozincite as the main component. The term "main component" refers to a component contained in the largest amount among the constituting substances, and the amount thereof is preferably not less than 50 mass% and more preferably not less than 60 mass%.

The basic zinc carbonate obtained by the precipitate forming reaction is subjected to heat treatment to be thereby decarboxylated and dehydrated, and the zinc oxide powder is obtained.

When the heat treatment temperature is too low, decarboxylation and dehydration may excessively occur during the firing process to thereby hinder the sintering in the production of the zinc oxide sintered body.

When the heat treatment temperature becomes high, the necking of the primary particles leads to formation of dense secondary particles, and a high untamped density and a high tap density can be achieved.

When the heat treatment temperature is too high, on the other hand, bonded particles in which the primary particles are bonded together may increase. A large bonded particle undergoes a rapid particle growth and becomes the larger sintered particle. This phenomenon is known as Ostwald ripening and may cause nonuniform particle size of the sintered body.

In view of the foregoing, the heat treatment temperature is preferably not lower than 250°C and more preferably not lower than 320°C. Meanwhile, the heat treatment temperature is preferably not higher than 700°C and more preferably not higher than 600°C.

[Zinc oxide sintered body]

The zinc oxide sintered body of the invention is a zinc oxide sintered body, in which the above-described zinc oxide powder of the invention is sintered. Hence, the zinc oxide sintered body of the invention contains the metal element M.

The zinc oxide sintered body of the invention is preferably a solid solution containing the metal element M.

Meanwhile, depending on the content thereof and/or the firing temperature, the metal element M may form a compound such as an oxide, which may be present as a subphase in the grain boundary of zinc oxide.

The zinc oxide sintered body of the invention is obtained by firing the zinc oxide powder of the invention (in particular, firing in the above-described specific atmosphere).

Specifically, for example, the zinc oxide powder of the invention is used as it is, or alternatively pulverized with a bead mill or granulated using a spray dryer, and subsequently compacted, and the obtained green compact is fired in the specific atmosphere. The zinc oxide sintered body of the invention is obtained in this manner.

The zinc oxide sintered body of the invention is used as a member made of ceramics.

Specifically, the zinc oxide sintered body of the invention can be suitably used as, for example, a member such as a sputter target or a varistor which requires highly uniform composition; a gas sensor such as a thick-film gas sensor which receives a repeated heating history; a filter such as an antibacterial filter for preventing growth of E. coli or the like; and a ceramic structure of a high-temperature furnace which is repeatedly heated.

EXAMPLES

The invention is specifically described below with reference to Examples. However, the present should not be construed as being limited to the following examples.

[Examples 1 to 6 and Comparative Example 1]

<Preparation of basic zinc carbonate>

Use was made of zinc nitrate hexahydrate (produced by Kishida Chemical Co., Ltd.) as a zinc salt, a nitrate or a chloride of the metal element M (produced by Kishida Chemical Co., Ltd.) as a salt of the metal element M, ammonium carbonate (produced by Kishida Chemical Co., Ltd.) as a carbonate and 7.4 mol/L ammonium water (produced by Kishida Chemical Co., Ltd.) as an alkali.

The metal element M contained in a nitrate or a chloride was the metal element M1-1 (Bi, Co, Cr, Cu, In, Ni, Mn or Sb) or the metal element MI-2 (Ba, Ce, La, Nb, Pr or Sr).

More specifically, as a salt (nitrate or chloride) of the metal element M1-1, use was made of bismuth (III) nitrate pentahydrate, cobalt (II) nitrate hexahydrate, chromium (III) nitrate nonahydrate, copper (II) nitrate trihydrate, indium (III) nitrate trihydrate, nickel (II) nitrate hexahydrate, manganese (II) nitrate hexahydrate, or antimony (III) chloride.

As a salt (nitrate or chloride) of the metal element M1-2, use was made of barium nitrate, cerium (III) nitrate hexahydrate, lanthanum nitrate hexahydrate, niobium (V) chloride, praseodymium (III) nitrate hexahydrate or strontium nitrate.

Zinc nitrate and a salt of the metal element M that were weighed to have a total amount of 1.0 mol were dissolved into 1L of pure water, whereby a mixed aqueous solution of zinc nitrate and a salt of the metal element M was prepared.

In Examples 1 to 6, the molar ratio of zinc nitrate and a salt of the metal element M (charge amounts) was adjusted such that the content of the metal element M meets each of the values shown in Table 1 below.

In Comparative Example 1, a salt of the metal element M was not added to prepare a blank material.

In a 2L beaker, 0.5L of 0.8M aqueous ammonium carbonate solution was prepared.

A pH electrode for pH control was provided in the aqueous ammonium carbonate solution. The mixed aqueous solution of zinc nitrate and a salt of the metal element M was added dropwise at a rate of 1L/h into the aqueous ammonium carbonate solution being stirred with a rotor that was set to a rotation speed of 700 rpm.

In order to prevent a decrease in pH of the aqueous ammonium carbonate solution owing to the dropwise addition of the acidic mixed aqueous solution of zinc nitrate and a salt of the metal element M, 7.4 mol/L ammonium water was added dropwise to the aqueous ammonium carbonate solution, using a liquid feeding pump regulated to be switched on and off by a pH controller (TDP-51, manufactured by Toko Kagaku Kenkyusho KK). Accordingly, the pH of the aqueous ammonium carbonate solution was kept at a constant value of 7.5 during the dropwise addition of the mixed aqueous solution of zinc nitrate and a salt of the metal element M. A precipitate was generated through the precipitate forming reaction in this manner.

After generation of the precipitate through the precipitate forming reaction was completed, the precipitate was subjected to the stirring for 20 hours by means of a rotor whose rotation speed was set to 700 rpm similarly to that during the precipitate forming reaction, whereby a slurry of the basic zinc carbonate containing the metal element M was obtained.

During the precipitate forming reaction and the stirring process, a cooling device was used so that the aqueous ammonium carbonate solution constantly had temperature lower than 30°C.

The slurry having been subjected to the stirring was separated into solid and liquid components by the suction filtration method, and a solid component was obtained. The obtained solid component was washed to remove undesired ammonium, nitrate, sodium or other components. Specifically, the solid component was converted into a slurry again using an appropriate amount of pure water, and the slurry thus obtained was separated into solid and liquid components by the suction filtration method. This washing process was repeated four times.

The washed solid component was dried in vacuum at 40°C for 20 hours using a vacuum dryer. Thus, dried powder of basic zinc carbonate containing the metal element M that is a precursor of zinc oxide powder was obtained.

The obtained basic zinc carbonate was subjected to X-ray diffraction using an X-ray diffractometer (D8ADVANCE, manufactured by BRUKER CORPORATION). The crystal phase was thus identified.

In addition, the thermal reduction was measured with a TG-DTA device (TG/DTA6300, manufactured by Hitachi High-Tech Corporation), the carbon analysis was carried out by the combustion method using an analyzer (CS844, manufactured by LECO Corporation), and Zn and the metal element M were analyzed using an ICP emission spectrometer (ICP-9000, manufactured by Shimadzu Corporation).

Based on the results of the X-ray diffraction and the component analyses, it was confirmed that basic zinc carbonate containing hydrozincite as a main component was obtained in Comparative Example 1 and Examples 1 to 6.

Meanwhile, when the filtrate was analyzed, it was found that the precipitate had a yield of not less than 90 mass%.

<Heat treatment: preparation of zinc oxide powder>

The basic zinc carbonate thus obtained was put in an alumina crucible and subjected to heat treatment at 420°C in an air atmosphere for decarboxylation and dehydration. The temperature increase rate was 5°C/min., the retaining time at 420°C was 6 hours, and the cooling step was natural cooling. Zinc oxide powder was obtained in this manner.

Of the obtained zinc oxide powder, Zn and the metal element M were analyzed using an ICP emission spectrometer (ICP-9000, manufactured by Shimadzu Corporation). Based on the results, it was confirmed that the contents of the metal element M with the values shown in Table 1 below were obtained.

<Production of green compact>

The obtained zinc oxide powder was sieved with a 0.6 mm sieve for a simple pulverization. The pulverized zinc oxide powder was weighed in an amount of 2g, which was press-formed under a pressure of 60 MPa, whereby a disc-like green compact of $\varphi$20 mm $\times$ 2 mm was produced.

<Firing: production of sintered body>

The disc-like green compact thus produced was fired in an air atmosphere. The firing temperature (highest temperature) was 1,300°C. The retaining time at the firing temperature was 6 hours, the temperature increase rate was 5°C/min., and the cooling step was carried out by leaving the body to stand in a furnace. A disc-like sintered body was obtained in this manner.

<Evaluation>

The green compact (zinc oxide powder) and the sintered body of each example were evaluated for the following items. The results are shown in Tables 1 and 2 below.

<<Mass reduction suppression ratio A>>

The masses of the green compact and the sintered body of each example were measured to the fourth decimal place using an electronic balance, and the mass reduction ratio $\Delta W$ (unit: %) was determined based on the following Formula (II) .

$$\Delta W = \{(\text{mass of green compact} - \text{mass of sintered body})/\text{mass of green compact}\} \times 100 \quad (II)$$

Subsequently, given that the mass reduction ratio $\Delta W$ (unit: %) of Comparative Example 1 where the metal element M was not added was "$\Delta W_0$" while the mass reduction ratio $\Delta W$ (unit: %) of each of Examples where the metal element M was added was "$\Delta W_M$" the mass reduction suppression ratio A (unit: %) of each example was determined based on the following Formula (III).

$$A = \{ (\Delta W_0 - \Delta W_M)/\Delta W_0 \} \times 100 \quad (III)$$

With the larger value of mass reduction suppression ratio A, the mass reduction suppression effect during the firing process of the zinc oxide powder (green compact) is evaluated as more excellent. Specifically, when the mass reduction suppression ratio A is larger than 0%, it is understood as being effective in mass reduction suppression, and the mass reduction suppression ratio A is preferably not less than 5%, more preferably not less than 20% and further preferably not less than 60%.

<<Volume resistivity>>

The volume resistivity (unit: $\Omega \cdot cm$) of the sintered body of each example was measured by the four-point probe method using a resistivity meter (Loresta A-GX, manufactured by Mitsubishi Chemical Corporation). With the lower value of volume resistivity, the conductivity is evaluated as more excellent.

[Table 1]

Table 1

| | | | Mass reduction suppression ratio A [%] | | | | | | |
|---|---|---|---|---|---|---|---|---|---|
| | | | Comparative Example | Example | | | | | |
| | | | 1 | 1 | 2 | 3 | 4 | 5 | 6 |
| | Content [mol ppm] | | 0 | 10 | 20 | 200 | 2000 (0.2 mol%) | 20000 (2 mol%) | 100000 (10 mol%) |
| | N.A. | | 0 | - | - | - | - | - | - |
| Metal element M | M1-1 | Bi | - | 4 | 7 | 16 | 12 | 3 | 1 |
| | | Co | - | 25 | 40 | 56 | 53 | 40 | 39 |
| | | Cr | - | 12 | 30 | 48 | 42 | 31 | 29 |
| | | Cu | - | 12 | 28 | 40 | 33 | 16 | 14 |
| | | In | - | 16 | 24 | 29 | 31 | 13 | 10 |
| | | Ni | - | 5 | 12 | 31 | 47 | 52 | 51 |
| | | Mn | - | 10 | 26 | 43 | 51 | 56 | 54 |
| | | Sb | - | 18 | 32 | 40 | 36 | 26 | 24 |
| | M1-2 | Ba | - | 6 | 10 | 20 | 14 | 6 | - |
| | | Ce | - | 10 | 26 | 32 | 28 | 16 | - |
| | | La | - | 8 | 14 | 26 | 22 | 10 | - |
| | | Nb | - | 18 | 28 | 33 | 35 | 18 | - |
| | | Pr | - | 28 | 37 | 45 | 37 | 1 | - |
| | | Sr | - | 14 | 18 | 21 | 21 | 20 | - |

[Table 2]

Table 2

| Metal element M | | | Volume resistivity [$\Omega \cdot$ cm] | | | | | | |
|---|---|---|---|---|---|---|---|---|---|
| | | | Comparative example | Example | | | | | |
| | | | 1 | 1 | 2 | 3 | 4 | 5 | 6 |
| | Content [mol ppm] | | 0 | 10 | 20 | 200 | 2000 (0.2 mol%) | 20000 (2 mol%) | 100000 (10 mol%) |
| | N.A. | | 615 | - | - | - | - | - | - |
| | M1-1 | Bi | - | 1000 | 3000 | $1 \times 10^6$ | $1 \times 10^9$ | $1 \times 10^9$ | $1 \times 10^9$ |
| | | Co | - | 600 | 400 | 379 | $2.1 \times 10^5$ | $1 \times 10^9$ | $1 \times 10^9$ |
| | | Cr | - | 800 | 500 | 450 | $6 \times 10^5$ | $8 \times 10^7$ | $1 \times 10^9$ |
| | | Cu | - | 1000 | $2.5 \times 10^5$ | $2 \times 10^8$ | $1 \times 10^9$ | $1 \times 10^9$ | $1 \times 10^9$ |
| | | In | - | 450 | 200 | 100 | 42 | $1 \times 10^6$ | $3.8 \times 10^8$ |
| | | Ni | - | 2000 | $1 \times 10^6$ | $1 \times 10^9$ | $1 \times 10^9$ | $1.4 \times 10^4$ | 1200 |
| | | Mn | - | 3000 | $4 \times 10^4$ | $5 \times 10^7$ | $1 \times 10^9$ | $1 \times 10^9$ | $1 \times 10^9$ |
| | | Sb | - | 560 | 420 | 379 | 8000 | $1 \times 10^9$ | $1 \times 10^9$ |
| | M1-2 | Ba | - | 500 | 580 | $1.3 \times 10^4$ | $7 \times 10^4$ | $1 \times 10^8$ | - |
| | | Ce | - | 700 | 4000 | $2 \times 10^6$ | $3 \times 10^8$ | $1 \times 10^9$ | - |
| | | La | - | 900 | 5000 | $4 \times 10^6$ | $6 \times 10^8$ | $1 \times 10^9$ | - |
| | | Nb | - | 1200 | 4500 | $5 \times 10^6$ | $8 \times 10^8$ | $1 \times 10^9$ | - |
| | | Pr | - | 600 | 900 | 1030 | $2.1 \times 10^4$ | $1 \times 10^9$ | - |
| | | Sr | - | 2000 | 3000 | $2 \times 10^5$ | $3.6 \times 10^6$ | $1 \times 10^9$ | - |

<Summary of Evaluation Results>

Table 1 above shows that the zinc oxide powders of Examples 1 to 6 had large values of mass reduction suppression ratio A, exhibiting excellent mass reduction suppression effect.

Referring to Examples 1 to 3, Example 2 where the content of the metal element M was 20 mol ppm exhibited the more excellent effect, compared to Example 1 where the content thereof was 10 mol ppm, and Example 3 where the content thereof was 200 mol ppm exhibited the further more excellent effect than that of Example 2.

When the metal element M1-1 was contained as the metal element M, Example 5 where the content of the metal element M was 2 mol% tended to have the more excellent effect, compared to Example 6 where the content thereof was 10 mol%.

When the metal element Ml-2 was contained as the metal element M, Example 4 where the content of the metal element M was 0.2 mol% tended to have the more excellent effect, compared to Example 5 where the content thereof was 2 mol%.

Table 2 above shows that, while a decrease in volume resistivity was seen in some of Examples, the volume resistivity tended to increase as the content of the metal element M increased in many of Examples. This tendency was significant when the metal element Ml-2 was contained as the metal element M.

[Example 7 and Example 8]

In addition, as a salt of the metal element M, aluminum nitrate nonahydrate (produced by Kishida Chemical Co., Ltd.) or gallium nitrate octahydrate (produced by Kishida Chemical Co., Ltd.) was used to prepare a mixed aqueous solution with zinc nitrate, and the mixed aqueous solution was added dropwise to an aqueous ammonium carbonate solution.

In the same manner as in Example 4 except for the above-described step, dried powder of basic zinc carbonate was obtained.

In Examples 7 and 8, the content of the metal element M1-1 or the metal element M1-2 was 1,800 mol ppm (0.18 mol%), and the content of the metal element M2 (Al or Ga) was 200 mol ppm.

Based on the results of the X-ray diffraction and the component analyses, it was confirmed that, in Examples 7 and 8, the basic zinc carbonate containing hydrozincite as a main component was obtained.

The obtained basic zinc carbonate was subjected to the heat treatment in an air atmosphere at 420°C in the same manner as in Example 4, and zinc oxide powder was obtained. The zinc oxide powder thus obtained was confirmed to be single-phase zinc oxide through the X-ray diffraction.

Further, using the obtained zinc oxide powder, production of a green compact, production of a sintered body (by firing in an air atmosphere at 1,300°C) and evaluation were carried out in the same manner as in Example 4. The results are shown in Tables 3 to 4 below.

[Table 3]

Table 3

| | | | Mass reduction suppression ratio A [%] | | | |
|---|---|---|---|---|---|---|
| | | | Comparative example | Example | Example | |
| | | | 1 | 4 | 7 | 8 |
| Metal element M | Content [mol ppm] | | 0 | 2000 | 1800 + 200Al | 1800 + 200Ga |
| | N.A. | | 0 | - | - | - |
| | M1-1 | Bi | - | 12 | 18 | 20 |
| | | Co | - | 53 | 52 | 54 |
| | | Cr | - | 42 | 40 | 42 |
| | | Cu | - | 33 | 35 | 36 |
| | | In | - | 31 | 32 | 32 |
| | | Ni | - | 47 | 43 | 45 |
| | | Mn | - | 51 | 49 | 49 |
| | | Sb | - | 36 | 36 | 36 |
| | M1-2 | Ba | - | 14 | 16 | 18 |
| | | Ce | - | 28 | 25 | 27 |
| | | La | - | 22 | 25 | 26 |
| | | Nb | - | 35 | 33 | 34 |
| | | Pr | - | 37 | 36 | 37 |
| | | Sr | - | 21 | 19 | 20 |

[Table 4]

Table 4

| | | | Volume resistivity [$\Omega \cdot$ cm] | | | |
|---|---|---|---|---|---|---|
| | | | Comparative example | Example | Example | |
| | | | 1 | 4 | 7 | 8 |
| Metal element M | Content [mol ppm] | | 0 | 2000 | 1800 + 200Al | 1800 + 200Ga |
| | N.A. | | 615 | - | - | - |
| | M1-1 | Bi | - | $1 \times 10^9$ | $3 \times 10^7$ | $1 \times 10^7$ |
| | | Co | - | $2.1 \times 10^5$ | $9 \times 10^4$ | $3 \times 10^4$ |
| | | Cr | - | $6 \times 10^5$ | $4 \times 10^4$ | 3500 |
| | | Cu | - | $1 \times 10^9$ | $5 \times 10^7$ | $1.5 \times 10^7$ |
| | | In | - | 42 | 38 | 30 |
| | | Ni | - | $1 \times 10^9$ | $1 \times 10^7$ | $5 \times 10^6$ |
| | | Mn | - | $1 \times 10^9$ | $9 \times 10^8$ | $2.5 \times 10^8$ |
| | | Sb | - | 8000 | 5000 | 3000 |
| | M1-2 | Ba | - | $7 \times 10^4$ | $2 \times 10^4$ | $6.5 \times 10^3$ |
| | | Ce | - | $3 \times 10^8$ | $8.5 \times 10^7$ | $1.5 \times 10^7$ |
| | | La | - | $6 \times 10^8$ | $8.5 \times 10^7$ | $1.5 \times 10^7$ |
| | | Nb | - | $8 \times 10^8$ | $9 \times 10^7$ | $3.5 \times 10^7$ |
| | | Pr | - | $2.1 \times 10^4$ | 7000 | 6000 |
| | | Sr | - | $3.6 \times 10^6$ | $2 \times 10^5$ | $9 \times 10^4$ |

Table 3 above shows that the mass reduction suppression ratios A in Examples 7 and 8 were substantially at the same level as in Example 4.

Meanwhile, Table 4 above shows that, compared to Example 4, there was a tendency where the value of volume resistivity decreases, while the conductivity improves in Examples 7 and 8. This is presumably because Al and Ga served as a conductive carrier.

[Example 9 and Example 10]

<Example 9>

In a 500 mL plastic container, 100 g of zinc oxide powder falling under JIS Grade 2 and cobalt oxide (II, III) powder were placed. An amount of cobalt oxide was set such that an amount of Co as the metal element M would be 200 ppm in the zinc oxide powder to be obtained. To the powders, 250 g of pure water and 250 g of zirconia balls with 5 mm diameter were added, and ball-mill mixing was carried out at a rotation speed of 100 rpm for 24 hours. Following the mixing, zirconia balls were separated. The resulting mixture was dried and then sieved with a sieve having an aperture of 300 $\mu$m for classification, whereby powder was obtained. The powder was regarded as zinc oxide powder of Example 9.

<Example 10>

In the same manner as in Example 9 except that an amount of cobalt oxide was changed such that an amount of Co as the metal element M would be 2,000 ppm, zinc oxide powder of Example 10 was obtained.

<Coefficient of variation C.V. value and integrated intensity ratio>

Of zinc oxide powder of each of Examples 9 and 10, the coefficient of variation C.V. value and the integrated intensity ratio were determined according to the above-described methods. The results are shown in Table 5 below.

In addition, of zinc oxide powder of each of Examples 3 and 4 (where the metal element M was Co), the coefficient of variation C.V. value and the integrated intensity ratio were also determined in the same manner. The results are shown in Table 5 below.

<Mass reduction suppression ratio A>

Given that the mass reduction ratio $\Delta W$ (unit: %) of JIS Grade 2 zinc oxide was "$\Delta W_{JIS}$" while the mass reduction ratio $\Delta W$ (unit: %) of each example was "$\Delta W_M$," the mass reduction suppression ratios A (unit: %) of Examples 9 and 10 were determined based on Formula (IV) below. The results are shown in Table 5 below.

$$A = \{(\Delta W_{JIS} - \Delta W_M)/\Delta W_{JIS}\} \times 100 \quad (IV)$$

The method for determining the mass reduction ratio $\Delta W$ does not differ from the above-described method.

The mass reduction suppression ratios A (unit: %) of zinc oxide powders of Examples 3 and 4 (where the metal element M was Co) are also shown in Table 5 below.

[Table 5]

Table 5

| | Example | | | |
|---|---|---|---|---|
| | 3 | 4 | 9 | 10 |
| Metal element M | Co | Co | Co | Co |
| Content [mol ppm] | 200 | 2000 | 200 | 2000 |
| Coefficient of variation C.V. value [%] | 21.7 | 17.9 | 56.7 | 177.4 |
| Integrated intensity ratio [%] | 0.03 | 0 | 2 | 16.3 |
| Mass reduction suppression ratio A [%] | 56 | 53 | 2.2 | 3.8 |

<Summary of Evaluation Results>

As shown in Tables above, zinc oxide powders of Examples 3 and 4 each had the coefficient of variation C.V. value of not more than 30% and the integrated intensity ratio of not more than 0.1%.

Meanwhile, zinc oxide powder of Examples 9 and 10 each had the coefficient of variation C.V. value of more than 30% and the integrated intensity ratio of more than 0.1%.

Compared to zinc oxide powders of Examples 9 and 10, zinc oxide powders of Examples 3 and 4 each had a large value of the mass reduction suppression ratio A and were found to have excellent mass reduction suppression effect.

**Claims**

1. Zinc oxide powder for producing a zinc oxide sintered body, the zinc oxide powder being used to produce a zinc oxide sintered body, containing a metal element M and satisfying Condition 1 or Condition 2 below:

    Condition 1

        the metal element M is a metal element M1-1 that is at least one selected from the group consisting of Bi, Co, Cr, Cu, In, Ni, Mn and Sb, or a combination of the metal element M1-1 and a metal element M2 that is at least one selected from the group consisting of Al and Ga, and

a content of the metal element M represented by Formula (I) below is not less than 10 mol ppm and not more than 10 mol%; and

Condition 2

the metal element M is a metal element M1-2 that is at least one selected from the group consisting of Ba, Ce, La, Nb, Pr and Sr, or a combination of the metal element M1-2 and a metal element M2 that is at least one selected from the group consisting of Al and Ga, and
a content of the metal element M represented by Formula (I) below is not less than 10 mol ppm and not more than 2 mol%,

$$\{ n_M / (n_{Zn} + n_M) \} \quad (I)$$

where $n_M$ represents an amount of substance of the metal element M in the zinc oxide powder, nzn represents an amount of substance of Zn in the zinc oxide powder, and a unit for both $n_{Zn}$ and $n_M$ is mole.

2. The zinc oxide powder for producing a zinc oxide sintered body according to claim 1, wherein a coefficient of variation C.V. value determined through EPMA mapping measurement of the metal element M is not more than 30%.

3. The zinc oxide powder for producing a zinc oxide sintered body according to claim 1, wherein an integrated intensity ratio determined through EPMA mapping measurement of the metal element M is preferably not more than 0.1%.

4. The zinc oxide powder for producing a zinc oxide sintered body according to any one of claims 1 to 3, wherein the zinc oxide powder is obtained by subjecting basic zinc carbonate containing the metal element M to heat treatment, the basic zinc carbonate being generated by a precipitate forming reaction of a salt of the metal element M with a zinc salt, a carbonate and an alkali.

5. A zinc oxide sintered body, wherein the zinc oxide powder for producing a zinc oxide sintered body according to any one of claims 1 to 4 is sintered.

6. The zinc oxide sintered body according to claim 5, wherein the zinc oxide sintered body is a sputter target, a gas sensor, a varistor or a ceramic structure of a high-temperature furnace.

7. A method for preparing zinc oxide powder for producing a zinc oxide sintered body, the method comprising: generating basic zinc carbonate containing the metal element M by a precipitate forming reaction of a salt of the metal element M with a zinc salt, a carbonate and an alkali; and
subjecting the basic zinc carbonate to heat treatment, whereby the zinc oxide powder for producing a zinc oxide sintered body according to any one of claims 1 to 4 is obtained.

8. A method for producing a zinc oxide sintered body, the method comprising: firing the zinc oxide powder for producing a zinc oxide sintered body according to any one of claims 1 to 4 in a high-temperature air atmosphere at not lower than 800°C or in a low-oxygen partial pressure atmosphere at not higher than $1.0 \times 10^{-3}$ MPa, whereby a zinc oxide sintered body into which the zinc oxide powder for producing a zinc oxide sintered body is sintered is obtained.

<table>
<tr><td colspan="2" align="center">**INTERNATIONAL SEARCH REPORT**</td><td colspan="2">International application No.<br>PCT/JP2020/030670</td></tr>
</table>

**A. CLASSIFICATION OF SUBJECT MATTER**
C01G 9/00(2006.01)i; H01C 7/112(2006.01)i; H01C 17/30(2006.01)i; C04B 35/453(2006.01)i; C23C 14/34(2006.01)i
FI: C04B35/453; C01G9/00 B; C23C14/34 A; H01C7/112; H01C17/30
According to International Patent Classification (IPC) or to both national classification and IPC

**B. FIELDS SEARCHED**

Minimum documentation searched (classification system followed by classification symbols)
C01G9/00; H01C7/112; H01C17/30; C04B35/453; C23C14/34

Documentation searched other than minimum documentation to the extent that such documents are included in the fields searched
| | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)
JSTPlus/JSTChina/JST7580 (JDreamIII)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 63-224303 A (DIRECTOR GENERAL OF NATIONAL INSTITUTE FOR RESEARCH IN INORGANIC MATERIALS OF SCIENCE AND TECHNOLOGY AGENCY) 19.09.1988 (1988-09-19) examples | 1–6, 8<br>7 |
| X<br>A | CN 104291790 A (UNIV CHANGZHOU) 21.01.2015 (2015-01-21) example 1, fig. 3 | 1–6, 8<br>7 |
| X<br>A | JP 2018-093143 A (KOA CORPORATION) 14.06.2018 (2018-06-14) paragraphs [0055]–[0063] | 1, 4–6, 8<br>2–3, 7 |
| P, X<br>P, A | WO 2019/235499 A1 (KOA CORPORATION) 12.12.2019 (2019-12-12) entire text | 1, 4–6, 8<br>2–3, 7 |

☐ Further documents are listed in the continuation of Box C.　　☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 17 September 2020 (17.09.2020) | 06 October 2020 (06.10.2020) |

| Name and mailing address of the ISA/<br>　Japan Patent Office<br>　3-4-3, Kasumigaseki, Chiyoda-ku,<br>　Tokyo 100-8915, Japan | Authorized officer<br><br>Telephone No. |
|---|---|

Form PCT/ISA/210 (second sheet) (January 2015)

INTERNATIONAL SEARCH REPORT

Information on patent family members

International application No.

PCT/JP2020/030670

| Patent Documents referred in the Report | Publication Date | Patent Family | Publication Date |
|---|---|---|---|
| JP 63-224303 A | 19 Sep. 1988 | (Family: none) | |
| CN 104291790 A | 21 Jan. 2015 | (Family: none) | |
| JP 2018-093143 A | 14 Jun. 2018 | US 2019/0322588 A1 paragraphs [0095]-[0106] WO 2018/105689 A1 DE 112017006173 T CN 110050313 A | |
| WO 2019/235499 A1 | 12 Dec. 2019 | JP 2019-212800 A entire text | |

Form PCT/ISA/210 (patent family annex) (January 2015)

**EP 4 015 458 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009269946 A